## Europäisches Patentamt

## European Patent Office

## Office européen des brevets

(11) Numéro de publication: **0 246 965**
**B1**

## (12) FASCICULE DE BREVET EUROPEEN

(45) Date de publication du fascicule du brevet:
**14.03.90**

(21) Numéro de dépôt: **87401120.8**

(22) Date de dépôt: **19.05.87**

(51) Int. Cl.⁴: **G11C 17/00**

(54) Dispositif de sécurité pour mémoire morte programmable électriquement.

(30) Priorité: **23.05.86 FR 8607386**

(43) Date de publication de la demande:
**25.11.87 Bulletin 87/48**

(45) Mention de la délivrance du brevet:
**14.03.90 Bulletin 90/11**

(84) Etats contractants désignés:
**DE FR GB IT**

(56) Documents cités:
**EP-A- 0 086 360**
**US-A- 4 453 074**

**PATENT ABSTRACTS OF JAPAN,**
**vol. 5, no. 169 (P-86)[841], 28 octobre 1981; &**
**JP-A-56 98 790**

(73) Titulaire: **THOMSON COMPOSANTS MILITAIRES ET SPATIAUX, 173, Bd Haussmann, F-75008 Paris(FR)**

(72) Inventeur: **Silvestre de Ferron, Gérard, Thomson-CSF SCPI-19, avenue de Messine, F-75008 Paris(FR)**

(74) Mandataire: **Ruellan-Lemonnier, Brigitte et al, THOMSON-CSF SCPI, F-92045 PARIS LA DEFENSE CEDEX 67(FR)**

## Description

La présente invention concerne un dispositif de sécurité pour les mémoires mortes programmables électriquement telles que les mémoires EPROM ou EEPROM. Elle concerne plus particulièrement un dispositif de sécurité pour les mémoires mortes programmables électriquement destinées à recevoir des informations confidentielles non modifiables par un fraudeur. De telles mémoires sont utilisées, par exemple, dans les cartes à mémoires appelées aussi cartes CCC.

En général, dans les mémoires du type ci-dessus, chaque élément de stockage d'information ou cellule mémoire est constitué par un transistor MOS à grille flottante qui peut être principalement de type FAMOS (pour floating gate avalanche injection MOS) ou de type SAMOS (pour stacked gate avalanche injection MOS). Le transistor MOS ci-dessus peut avoir deux états. Pour un transistor MOS à canal N dans un premier état aucune charge n'est piégée sur la grille flottante. Un canal de conduction peut exister entre source et drain. Le transistor conduit alors et se comporte comme un interrupteur fermé. Dans un deuxième état, des électrons ont été piégés sur la grille flottante. Ils empêchent la création d'un canal de conduction dans le substrat entre source et drain. Dans ce cas, le transistor est bloqué et se comporte comme un interrupteur ouvert.

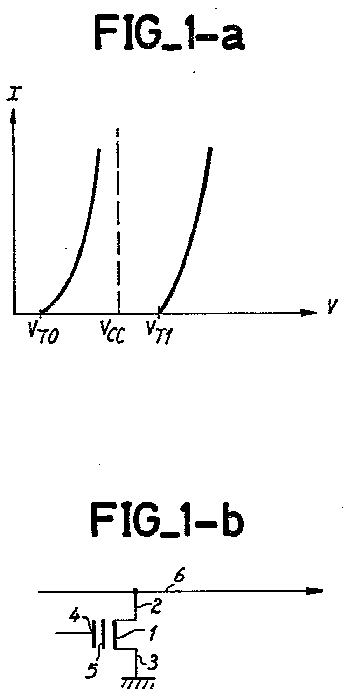

Pour programmer un transistor MOS 1 du type de celui représenté sur la figure 1B, des tensions plus élevées que la tension de fonctionnement normale sont convenablement appliquées sur la grille de commande 4 et l'électrode 2 de sorte que la grille flottante 5 absorbe et garde une charge d'électrons. Cette charge d'électrons sur la grille flottante 5 augmente le seuil de conduction sur la grille de commande 4 du transistor, de la tension de seuil minimale $V_{T0}$ des transistors non programmés à une tension de seuil supérieure $V_{T1}$ comme représenté sur la figure 1A qui donne le diagramme de la caractéristique de fonctionnement d'un transistor à grille flottante de type SAMOS.

Pour lire une mémoire ainsi programmée, une tension Vcc inférieure à la tension de seuil $V_{T1}$ des transistors programmés, mais supérieure à la tension minimale $V_{T0}$ des transistors non programmés doit être appliquée sur la grille de commande. Cette tension de lecture permet de détecter l'état passant ou bloqué du transistor. Comme représenté sur la figure 1B, de manière générale, le transistor 1 est relié par l'électrode 2 à une ligne de bit 6 polarisée en tension par un générateur. L'autre électrode 3 du transistor est reliée à la masse. La ligne de bit 6 est également reliée à un senseur de courant non représenté. Ce senseur mesure le courant débité dans la ligne par le générateur. Si la cellule mémoire n'a pas été programmée, le transistor est passant, et lors de l'application de la tension de lecture Vcc qui est supérieure à $V_{T0}$, le transistor est mis en saturation. On détecte sur le senseur une chute de courant. Dans le deuxième cas, lorsque la cellule mémoire a été programmée, des charges sont piégées sur la grille flottante du transistor. La tension de lecture Vcc appliquée sur la grille de commande est, dans ce cas, de sens opposé à la barrière de potentiel créée dans le canal de conduction par les charges stockées dans la grille flottante. Mais elle est alors insuffisante pour modifier la conduction du canal et le transistor reste bloqué. En conséquence, le senseur en bout de la ligne de bit ne perçoit pas de variation de courant.

Lorsque les mémoires ci-dessus sont utilisées dans les cartes à mémoire, le fabricant programme un certain nombre d'informations dont certaines doivent, de manière absolue, être infalsifiables. De telles informations sont, par exemple, le code secret de l'utilisateur. Or si l'on utilise pour la tension de lecture Vcc une tension supérieure à la tension de seuil $V_{T1}$, quel que soit l'état programmé ou non programmé des cellules mémoires, on détecte sur les senseurs une chute de courant. En conséquence, on lit l'ensemble des cellules mémoires du code secret comme si elles n'étaient pas programmées.

Pour remédier à cet inconvénient, on a proposé par exemple d'utiliser des bits témoins, c'est-à-dire des points programmés une seule fois. Dans ce cas, si l'on essaie d'effacer le code, les bits témoins sont forcément effacés et la carte est invalidée. La carte ne peut donc plus être utilisée.

La présente invention propose une nouvelle solution pour remédier à cet inconvénient qui permette de réutiliser la carte à mémoire.

En conséquence, la présente invention réalise un dispositif de sécurité pour une mémoire morte programmable électriquement comportant une matrice de cellules mémoires constituées chacune par un transistor MOS à grille flottante présentant après programmation une tension de seuil définie, chaque cellule étant accessible par des lignes et des colonnes reliées à des moyens permettant d'appliquer sur ces lignes et ces colonnes des potentiels représentatifs des informations à enregistrer dans les cellules ou de commande de lecture des informations enregistrées, caractérisé en ce qu'il est constitué par au moins une cellule mémoire témoin inclue dans la mémoire, cette cellule-mémoire témoin présentant une tension de seuil après programmation inférieure au minimum de la dispersion des tensions de seuil des transistors de la matrice.

Une cellule mémoire dont la tension de seuil après programmation est inférieure au minimum de la dispersion des tensions de seuil des transistors de la matrice peut être réalisée de différentes manières.

Selon un mode de réalisation préférentiel, une cellule mémoire conforme à la présente invention présentera un L effectif plus grand que celui des autres cellules-mémoire.

Selon un autre mode de réalisation, une cellule mémoire conforme à la présente invention présentera un γ, à savoir un couplage entre grille flottante - grille de commande - substrat plus faible que celui des autres cellules-mémoire. Ceci peut être obtenu soit en augmentant la capacité grille flottante-substrat, soit en diminuant la capacité grille flottante-grille de commande.

Selon encore un autre mode de réalisation de la présente invention, la tension de seuil de la cellule mémoire témoin peut être abaissée en augmentant la valeur de la résistance de charge lors de la programmation.

Selon encore un autre mode de réalisation, la tension de seuil de la cellule mémoire témoin peut être abaissée en augmentant la résistance de source. Dans ce cas toutefois, la cellule mémoire doit être positionée à la périphérie de la matrice ou champ mémoire, car l'on augmente la longueur de la zone diffusée.

Selon un autre mode de réalisation facilement mis en oeuvre, on peut réaliser une cellule mémoire présentant une tension de seuil abaissée en abaissant le temps et/ou la tension de programmation. Toutefois, cette solution abaisse la durée de vie de la mémoire, comme cela est bien connu de l'homme de l'art. De fait, elle ne peut être envisagée que pour des mémoires dont la durée de vie est inférieure à 10 ans.

D'autres caractéristiques et avantages de la présente invention apparaîtront à la lecture de la description d'un mode de réalisation faite ci-après avec référence aux dessins ci-annexés dans lesquels :

- les figures 1A et 1B déjà décrites représentent respectivement la caractéristique tension-courant d'une cellule mémoire avec transistor à grille flottante et ladite cellule mémoire avec transistor à grille flottante,
- les figures 2A et 2B représentent respectivement les caractéristiques tension-courant de deux cellules mémoires programmées à "0" et à "1" et d'une cellule mémoire témoin conforme à la présente invention ainsi qu'une partie d'un champ mémoire comportant ladite cellule mémoire témoin, et
- la figure 3 représente une vue en coupe d'une cellule mémoire à transistor à grille flottante.

Pour simplifier la description, sur les dessins les mêmes références désignent les mêmes parties.

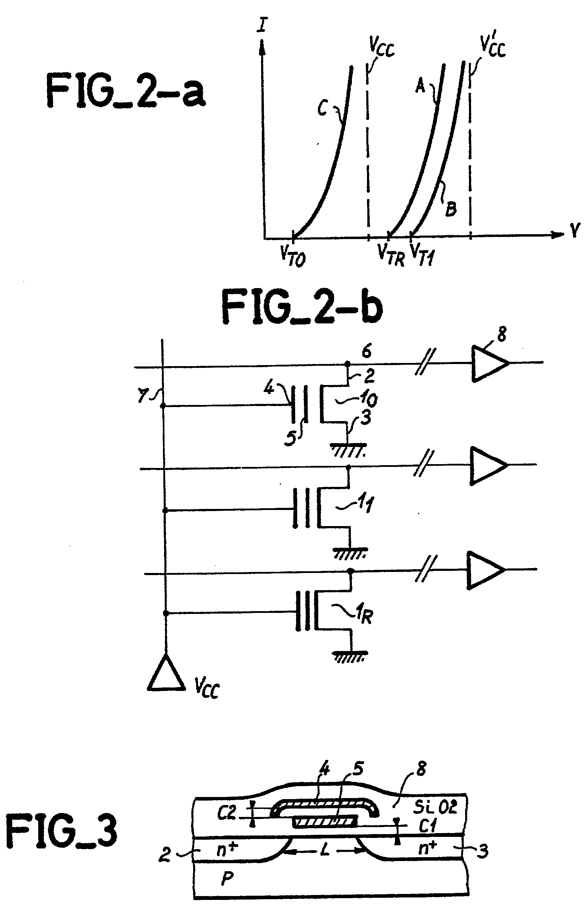

On a représenté sur la figure 2B, trois cellules-mémoire d'une même colonne. Ces cellules-mêmoire sont constituées chacune par un transistor à grille flottante de même type que le transistor à grille flottante de la figure 1B. Parmi les trois cellules mémoire représentées, la cellule-mémoire référencée 1R constitue une cellule-mémoire témoin conforme à la présente invention. Cette cellule-mémoire est de structure identique aux autres cellules-mémoire, mais elle présente une tension de seuil après programmation inférieure au minimum de la dispersion des tensions de seuil des transistors de la matrice. Les autres cellules-mémoire référencées $1_0$ et $1_1$ représentent respectivement une cellule-mémoire programmée à "0" et une cellule-mémoire programmée à "1".

De manière plus spécifique, comme représenté sur la figure 2B, chaque cellule mémoire $1_0$, $1_1$, $1_R$ de la mémoire morte programmable électriquement est due type à transistor avec grille flottante 5. Les transistors possèdent deux électrodes principales respectivement 3 et 2 et une grille de commande 4 empilée sur la grille flottante 4. Une des électrodes principales, à savoir l'électrode 3 dans le mode de réalisation représenté, est reliée à la masse tandis que l'électrode 2 est reliée à une ligne 6 dite ligne de bit. La grille de commande 4 est reliée à une autre connexion 7 dite ligne de mot. Les lignes de bit et lignes de mot sont arrangées en lignes et en colonnes pour déterminer une matrice incluant les cellules-mémoire. Cette mémoire comporte d'autre part des moyens connus de l'homme de métier et non représentés, tels qu'un décodeur ligne et un décodeur colonne pour appliquer sur les lignes et les colonnes des potentiels représentatifs d'informations à enregistrer ou représentatifs de commande de lecture des informations.

Ainsi, pour la lecture d'une cellule-mémoire, on fait passer dans la ligne de bit 6, un courant produit par une sortie du décodeur ligne. Au moyen du décodeur colonne, on envoie sur la ligne de mot 9 une impulsion de commande Vcc. Le transistor devient passant ou reste bloqué selon que des charges n'ont pas ou ont été au préalable piégées sur la grille flottante 4. Un senseur de courant 8 connecté par ailleurs à chaque extrémité de lignes de bit 6 détecte la variation ou l'absence de variation de courant. Il en déduit que la cellule-mémoire était programmée à un ou à zéro respectivement.

Conformément à la présente invention, on prévoit dans le champ mémoire au moins une cellule-mémoire témoin dont la tension de seuil après programmation est inférieure au minimum des tensions de seuil des transistors de la matrice. Comme mentionné ci-dessus, cette cellule-mémoire témoin est la cellule $1_R$ dans le mode de réalisation représenté sur la figure 2B. La tension de seuil $V_{TR}$ de cette cellule après programmation étant inférieure aux tensions de seuil après programmation des autres cellules, la cellule $1_R$ présente la caractéristique tension-courant donnée par la ccurbe A. D'autre part, la cellule-mémoire $1_1$ programmée à "1" présente la caractéristique tension-courant donnée par la courbe B avec une tension de seuil $V_{T1}$ et la cellule-mémoire $1_0$ programmée à "0" présente la caractéristique tension-courant donnée par la courbe C avec une tension de seuil $V_{T0}$.

De ce fait, si lors de la lecture, on applique une impulsion Vcc normale, à savoir une impulsion Vcc telle que $V_{T0}<Vcc<V_{TR}<V_{T1}$ on détecte une variation de courant sur le senseur 8 relié à la cellule-mémoire $1_0$ programmée à "0" et un courant nul sur les senseurs reliés respectivement à la cellule-mémoire $1_1$ programmée a "1" et à la cellule-mémoire témoin.

Toutefois, si lors de la lecture, on applique une impulsion V'cc frauduleuse, à savoir une impulsion V'cc telle que $V_{T0}<V_{TR}<V_{T1}<V'cc$, on détecte une variation de courant sur les senseurs.

Ce type de lecture est réalisé grâce à un logiciel qui sélectionne les mots mémoires ainsi que les lignes de bit. Aussi, pour éviter toute fraude, il suffit de lire tout d'abord la cellule-mémoire témoin. Si on ne détecte au niveau de cette cellule aucune variation de courant, cela signifie que l'impulsion de lecture présente une tension Vcc normale. Alors, on autorise la lecture des autres cellules. Au contraire, si on détecte une variation de courant, cela signifie que la tension V'cc de l'impulsion de lecture est trop forte. Il y a donc tentative de fraude et on interdit alors la lecture des autres cellules-mémoire.

Dans le cas de la présente invention, il suffit donc d'une cellule-mémoire témoin pour tout le champ mémoire. Il est toutefois possible d'utiliser plusieurs cellules, si on le désire. D'autre part, la cellule-mémoire témoin n'est pas effacée lors de la lecture. La mémoire et en particulier la carte contenant cette mémoire peuvent être réutilisées sans problème.

Différents moyens peuvent être utilisés pour diminuer la tension de seuil d'une cellule-mémoire à transistor à grille flottante. Pour illustrer certains de ces moyens, on a représenté sur la figure 3 une vue en coupe d'un transistor à grille flottante. Il s'agit, dans le mode de réalisation représenté, d'un transistor MOS à canal N. Les électrodes 2 et 3 sont constituées par des diffusions n+ dans un substrat de type p. La grille flottante 5 et la grille de commande 4 sont réalisées, par exemple, en silicium polycristallin. L'isolant 8 est lui réalisé en oxyde de silicium $SiO_2$.

Pour diminuer la tension de seuil, on peut selon un mode de réalisation préférentiel, augmenter le L effectif du canal. En effet, si on augmente la longueur du canal de $0,25\mu$ pour une longueur initiale de $3\mu$, la tension de seuil passe de 8V à 7V.

D'autre part, on peut modifier la tension de seuil en modifiant le $\gamma$, c'est-à-dire le couplage entre grille flottante-grille de commande-substrat. On obtient une diminution du $\gamma$, soit en augmentant la capacité $C1$ grille flottante-substrat, soit en diminuant la capacité $C2$ grille flottante-grille de commande. Ainsi, en diminuant le $\gamma$ de 0,74 à 0,7, la tension de seuil passe de 8V à 7V. Toutefois, cette caractéristique est plus difficile à contrôler.

D'autres moyens peuvent être utilisés, comme mentionné dans l'introduction.

On peut augmenter la résistance de source en augmentant la longueur de la zone diffusée n+2. Dans ce cas, la cellule-mémoire doit être positionnée à la périphérie du champ mémoire.

On peut aussi augmenter la valeur de la résistance de charge lors de la programmation. Toutefois, la résistance de charge étant commune à plusieurs cellules, en général une colonne, il faudra éventuellement prévoir une résistance de charge spécifique. Ainsi, en faisant passer la résistance de charge de 4 k$\Omega$ à 8 k$\Omega$, la tension de seuil chute de 2,5 V.

Il est aussi possible d'utiliser le temps de programmation et/ou la tension de programmation pour modifier la tension de seuil. Si la tension de programmation passe de 21 V à 19 V, la tension de seuil chute de 1,5 V. D'autre part, si le temps de programmation passe de 50 ms à 100 µs, la tension de seuil chute de 1 volt. Cette dernière solution n'est envisageable que si la rétention peut être inférieure à 10 ans.

## Revendications

1. Un dispositif de sécurité pour mémoire morte programmable électriquement comportant une matrice de cellules-mémoires ($1_0$, $1_1$, $1_R$) constituées chacune par un transistor MOS à grille flottante présentant après programmation une tension de seuil définie, chaque cellule étant accessible par des lignes (6) et des colonnes (9) reliées à des moyens permettant d'appliquer sur ces lignes et ces colonnes des potentiels représentatifs des informations à enregistrer dans les cellules ou de commande de lecture des informations enregistrées, caractérisé en ce qu'il est constitué par au moins une cellule-mémoire témoin ($1_R$) inclue dans la mémoire, cette cellule-mémoire témoin présentant une tension de seuil après programmation inférieure au minimum de la dispersion des tensions de seuil des transistors de la matrice.

2. Un dispositif selon la revendication 1, caractérisé en ce que la cellule-mémoire témoin ($1_R$) est constituée par un transistor MOS à grille flottante dont la longueur (L) effectif du canal est plus grand que celle des autres cellules-mémoire.

3. Un dispositif selon la revendication 1, caractérisé en ce que la cellule-mémoire témoin ($1_R$) est constituée par un transistor MOS à grille flottante dont le couplage entre grille flottante-grille de commande-substrat est plus faible que celui des autres cellules-mémoire.

4. Un dispositif selon la revendication 3, caractérisé en ce que le couplage plus faible que celui des autres cellules-mémoire est obtenu en diminuant la capacité grille flottante-grille de commande.

5. Un dispositif selon la revendication 3, caractérisé en ce que le coulage plus faible que celui des autres cellules-mémoire est obtenu en augmentant la capacité grille flottante-substrat.

6. Un dispositif selon la revendication 1, caractérisé en ce que la tension de seuil de la cellule-mémoire témoin est abaissée par rapport à celle des autres cellules, en augmentant la valeur de la résistance de charge lors de la programmation.

7. Un dispositif selon la revendication 1, caractérisé en ce que la cellule-mémoire témoin ($1_R$) est constituée par un transistor MOS à grille flottante dont la résistance de source est augmentée par rapport à celle des autres cellules.

8. Un dispositif selon la revendication 1, caractérisé en ce que la tension de seuil de la cellule-mémoire témoin est abaissée par rapport à celle des autres cellules, en diminuant le temps et/ou la tension de programmation.

## Claims

1. A security device for an electrically programmable rom comprising a matrix of memory cells ($1_0$, $1_1$ and $1_R$) each constituted by an MOS transistor with a floating gate having, after being programmed, a defined threshold voltage, each cell being able to be addressed by lines (6) and columns (9) connected with means making it possible to apply thereto potentials representative of the information to be recorded in the cells or to read out the recorded information, characterized in that it is made up of at least one pilot memory cell ($1_R$) included in the memory, this pilot memory cell having a threshold voltage after programming less than the minimum of the scatter of the threshold voltages of the transistors of the matrix.

2. The device as claimed in claim 1, characterized in that the pilot memory cell (1 R) is made up of a floating gate MOS transistor whose effective channel length le(L) of the channel is stronger than that of the other memory cells.

3. The device as claimed in claim 1, characterized in that the pilot memory cell (1R) is made up of a floating gate MOS transistor whose coupling of the floating gate floating gate to the control gate to the substrate is weaker than that of the other memory cells.

4. The device as claimed in claim 3, characterized in that the coupling which is weaker that of the other memory cells is obtained by diminishing the floating gate to control gate capacitance.

5. The device as claimed in claim 3, characterized in that the coupling which is weaker than that of the other memory cells is obtained by increasing the floating gate to substrate capacitance.

6. The device as claimed in claim 1, characterized in that the threshold voltage of the pilot memory cell is lowered in relation to those of the other cells by increasing the value of the charge resistance at the time of programming.

7. The device as claimed in claim 1, characterized in that the pilot memory cell (1R) is made up of a floating gate MOS transistor whose source resistance is increased in relation to that of the other cells.

8. The device as claimed in claim 1, characterized in that the threshold voltage of the pilot memory cell is lowered in relation to that of the other cells by decreasing the time and/or the voltage of programming.

## Patentansprüche

1. Eine Sicherheitsvorrichtung für elektrisch programmierbaren Festspeicher mit einer Matrix Speicherzellen (1₀, 1₁, 1R), von denen jede aus einem MOS-Transistor mit offenem Gate besteht, das nach Programmierung eine definierte Schwellenspannung aufweist, wobei jede Zelle durch Zeilen (6) und Spalten (9) zugänglich ist, die mit Mitteln verbunden sind, die ermöglichen, an diese Zeilen und Spalten Potentiale anzulegen, die für die in den Zellen aufzuzeichnenden Informationen oder die Steuerung zum Auslesen der gespeicherten Informationen repräsentativ sind, dadurch gekennzeichnet, daß sie aus mindestens einer im Speicher enthaltenen Anzeige-Speicherzelle (1R) besteht, wobei diese Anzeige-Speicherzelle nach Programmierung eine Schwellenspannung aufweist, die das Streuungsminimum der Schwellenspannungen der Matrix-Transistoren unterschreitet.

2. Eine Vorrichtung nach Anspruch 1, dadurch gekennzeichnet, daß die Anzeige-Speicherzelle (1R) aus einem MOS-Transistor mit freiem Gate besteht, bei dem die effektive Kanallänge größer ist als die der anderen Speicherzellen.

3. Eine Vorrichtung nach Anspruch 1, dadurch gekennzeichnet, daß die Anzeige-Speicherzelle (1R) aus einem MOS-Transistor mit freiem Gate besteht, bei dem die Kopplung zwischen freiem Gate-Substrat-Steuergate schwächer ist als diejenige der anderen Speicherzellen.

4. Eine Vorrichtung nach Anspruch 3, dadurch gekennzeichnet, daß die Kopplung, die schwächer als die der anderen Speicherzellen ist, durch Verminderung der Kapazität offenes Gate-Steuergate erreicht wird.

5. Eine Vorrichtung nach Anspruch 3, dadurch gekennzeichnet, daß die Kopplung, die schwächer als die der anderen Speicherzellen ist, durch Erhöhung der Kapazität offenes Gate-Substrat erreicht wird.

6. Eine Vorrichtung nach Anspruch 1, dadurch gekennzeichnet, daß die Schwellenspannung der Anzeige-Speicherzelle gegenüber derjenigen der anderen Zellen gesenkt wird, indem der Wert des Lastwiderstandes bei der Programmierung erhöht wird.

7. Eine Vorrichtung nach Anspruch 1, dadurch gekennzeichnet, daß die Anzeige-Speicherzelle (1R) aus einem MOS-Transistor mit freiem Gate besteht, dessen Quellwiderstand gegenüber dem der anderen Zellen erhöht wird.

8. Eine Vorrichtung nach Anspruch 1, dadurch gekennzeichnet, daß die Schwellenspannung der Anzeige-Speicherzelle gegenüber derjenigen der anderen Zellen gesenkt wird, indem die Programmierzeit und/oder -spannung verringert wird.

# FIG_1-a

# FIG_1-b

# FIG_2-a

# FIG_2-b

# FIG_3